# EUROPEAN PATENT SPECIFICATION

(11) **EP 3 229 569 B1**
(45) Date of publication and mention of the grant of the patent: **19.08.2020**
(21) Application number: 17397509.5
(22) Date of filing: 03.04.2017
(51) Int. Cl.: H05K 5/06, F21V 31/00, F16J 15/00, F21V 3/02, F21V 17/12, F21V 15/015, F21Y 103/00, F21Y 115/10

(54) **SEALING ARRANGEMENT FOR AN ELECTRONIC DEVICE**
DICHTUNGSANORDNUNG FÜR EINE ELEKTRONISCHE VORRICHTUNG
AGENCEMENT D'ÉTANCHÉITÉ POUR UN DISPOSITIF ÉLECTRONIQUE

(30) Priority: 08.04.2016 FI 20165303
(43) Date of publication of application: 11.10.2017
(73) Proprietor: Atexor Oy, 02630 Espoo (FI)
(72) Inventor: Mäkelä, Vesa, 92100 Lapua (FI)
(74) Representative: Berggren Oy, Tampere

(56) References cited:
- EP-A1- 2 918 908
- DE-A1-102010 017 460
- JP-A- 2007 227 305
- JP-A- 2013 020 857
- US-A1- 2003 098 550
- US-A1- 2012 018 443
- US-B2- 7 227 757

## Description

### Technical field

The present invention relates to a sealing apparatus for an electronic device which has a cover. The invention also relates to an electronic device comprising a cover.

### Background

Environments in which a risk of explosions may exist may be called, for example, hazardous areas or hazardous locations. The risk of explosions may be due to existence of explosive materials in such areas, such as dust, explosive gases, etc. This kinds of hazardous locations are, for example, petrochemical plants, coal mines, etc. Furthermore, such hazardous locations may exist in areas which are normally safe. For example, fuel containers may be stored in service buildings.

A housing of an electronic device such as a luminaire to be used in hazardous areas should often be substantially gas tight so that gases which may exist in the hazardous area could not enter the housing of the luminaire. It may also be recommended to avoid moisture entering the housing. To fulfil such requirements the housing should be as tight as possible. Therefore, some kind of seals or gaskets have been used to make the housing substantially tight. Gaskets may have between introduced between the parts which are coupled together. However, parts which are attached together may have different temperature coefficients which may cause that the gasket may move or for other reasons may not be able to keep the attachment tight enough. There is thus a need for an improved sealing arrangement for housings of electronic devices.

EP 2 918 908 discloses an explosion-proof lighting system adapted for use in explosion-risk areas is described. The lighting system comprises three coaxially aligned cylindrical bodies. These bodies are joined through mechanic and electric interconnections. The mechanical interconnections include a ring nut, NPT threads and gaskets. The transparent cylindrical tube is integrally secured e.g. by gluing or welding to one end of the connection cylinder and the other end is integrally secured to the threaded sealing cylinder. Both ends are sealed with O-ring gaskets.

JP 2013 020857 discloses an explosion-proof lighting device using an LED lamp. A cylindrical and translucent first explosion-proof tube surrounds the straight-tube LED lamp, and is surrounded by a translucent second explosion-proof tube made of glass. The first explosion-proof tube is made of polycarbonate resin or acrylic resin with a thickness of 2.5 mm or more and 3.5 mm or less. An inside space in which the straight-tube LED lamp is arranged is completely separated from an ambient atmosphere to prevent flame travel. The second explosion-proof tube is so made not to expose a surface of the first explosion-proof tube to an ambient atmosphere, so that accident due to static charge of the surface of the first explosion-proof tube is prevented.

### Summary

An aim of the present invention is to provide an improved sealing arrangement for an electronic device. The invention is based on the idea of providing a form to a combination of a gasket, an end element and a support element which together cause a force to the gasket which compresses the gasket towards a cover of the electronic device.

In accordance with a first aspect of the present invention there is provided a sealing apparatus for an electronic device comprising a cover, the sealing apparatus comprising:
a gasket having an outer circumference, an inner circumference, and at least a first side;
an end adapter; and
a support element for the gasket,
The sealing apparatus is characterized by what is disclosed in the characterizing part of claim 1.

In accordance with a second aspect of the present invention there is provided an electronic device comprising:
a cover;
a gasket having an outer circumference, an inner circumference, and at least a first side;
a support element for the gasket; and
at least one end adapter for closing the cover,
The electronic device is characterized by what is disclosed in the characterizing part of claim 7.

The present invention has several advantages. As an example, the structure of the gasket, the end adapter and the support element makes it possible to maintain the electronic device substantially gas tight and moisture tight also when the temperature of the operation environment of the luminaire changes. In other words, although different parts of the electronic device may have different temperature coefficients, the gasket is forced against a surface of the cover strong enough to maintain the tightness of the electronic device.

### Brief description of the drawings

In the following the present invention will be described in more detail with reference to the appended drawings in which
- Figure 1: depicts an electronic device as a perspective view, in accordance with an embodiment;
- Figure 2: depicts a cross section of one end of the electronic device of Figure 1, in accordance with an embodiment;
- Figure 3: illustrates behaviour of the gasket, the support element, the end adapter and the cover due to temperature changes, in accordance with an embodiment; and
- Figures 4a to 4g: depict some examples of cross sections of the sealing apparatus;
- Figure 5: depicts a cross section of one end of an electronic device, in accordance with another embodiment; and
- Figure 6: depicts a cross section of one end of an electronic device, in accordance with yet another embodiment.

### Detailed description

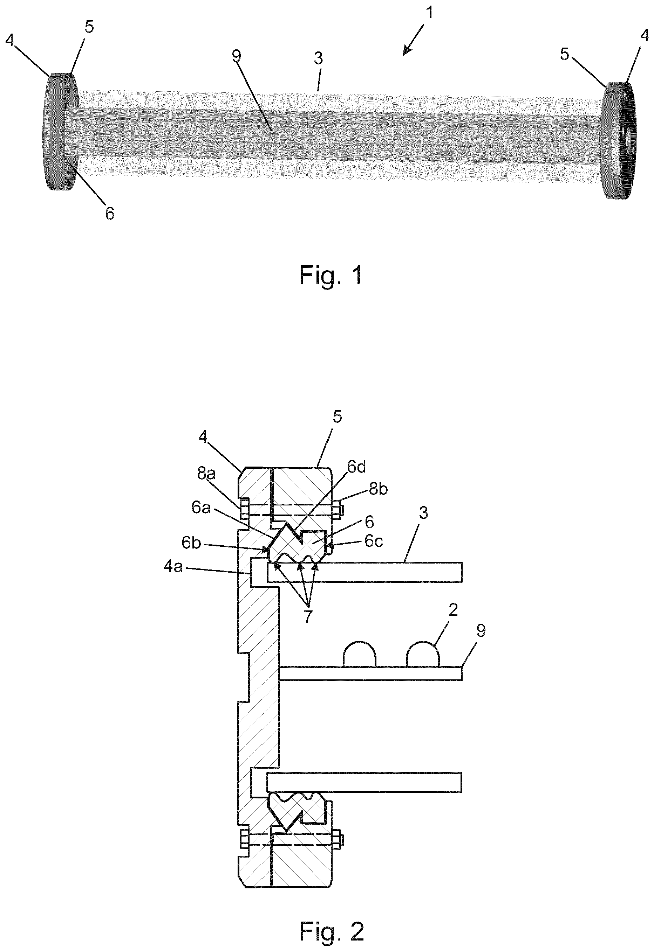

In the following the structure of the electronic device 1 of Figure 1 will be described. In this example the electronic device 1 is a luminaire but it may also be another electronic device, such as a transformer. According to this example embodiment, the luminaire 1 comprises one or more light sources 2, such as light emitting diodes (LED), a fluorescent tube, or the like. The light sources 2 and possible electrical/electronic control circuitry (not shown) may be attached with a substrate 9, such as a printed circuit board and/or an aluminium list. The luminaire 1 also comprises a cover 3, which is at least partly transparent to enable light illuminated by the one or more light sources 2 exiting the illuminator. However, if the electronic device is not a luminaire or other device illuminating light, the cover 3 may not need to be transparent at all but may be opaque. One purpose of the cover 3 is to protect the at least one light source against environmental forces, mechanical forces, etc. In this embodiment the cover 3 is an elongated tube but may also have a different kind of form. The cross section of the cover 3 may be circular, elliptical, triangular, or rectangular, for example. The cover 3 of the luminaire 1 is closed by end adapters 4 at both ends 3a, 3b of the cover 3.

Next, the structure of the end sections of the luminaire 1 will be described in more detail with reference to Figure 2. The end sections comprise a support element 5, which surrounds the cover 3 near the end of the cover 3. There is also a gasket 6 between the outer circumference of the cover 3 and the inner circumference of the support element 5, as can be seen from Figure 2. The end section of the cover 3 is closed by the end adapter 4. The end adapter 4 and the support element 5 may be attached with each other by screws and nuts, by glueing, or by another appropriate attachment method. It may be desired to enable opening the cover e.g. for servicing the luminaire 1, wherein gluing may not be suitable for such luminaires.

It should be noted here that the end sections may be similar to each other or there may be some differences between the end sections. For example, one of the end adapter 4 may comprise one or more feed-thru connectors and/or one or more lead-throughs for leading cables into the luminaire 1, whereas the other end adapter 4 may comprise a uniform plate.

In accordance with an embodiment, an inner circumference of the gasket 6 is adapted to be positioned on an outer surface of the cover 3 so that the contact surface between the inner circumference of the gasket 6 and the outer surface of the cover 3 forms an uninterrupted contact area around the cover 3. In other words, there should not be slits, holes, gaps or other apertures which could significantly weaken the tightness of the sealing between the gasket 6 and the cover 3. The arrows 7 in Figure 2 illustrates some examples of points of contacts between the gasket 6 and the cover 3.

The gasket 6 has a first conical section 6a on one side 6b of the gasket 6. That side is adapted to be faced towards the end adapter 4 when the gasket 6 and the end adapter 4 have been fixed to the cover 3. The other, opposite side 6c of the gasket may be flat, as is shown in Figure 2, or may have some other form. In accordance with an embodiment, the outer circumference of the gasket 6 has a second conical section 6d, such as a groove and/or a protrusion, to improve the response of the gasket to different temperature behaviour between the cover 3 and the end adapter 4 as will be explained next.

The illuminator 1 may be assembled e.g. as follows. The light source 2 and possible electrical/electronic control circuitry may be installed into the cover 3. The cover 3 may be pushed through a hole of the support element 5 so that a part of the cover extends through the support element 5. Then the gasket 6 is placed on the outer circumference of the cover 3, near the end 3a of the cover 3 and inside the support element 5. The end 3a of the cover 3 can now be closed by placing the end 3a of the cover 3 into a slit 4a of the end adapter 4. Now, the end adapter 4 and the support element 5 can be fixed together e.g. by screws 8a and nuts 8b. Hence, the structure according to Figure 2 has been obtained. The other end 3b of the cover 3 may be provided with the similar end section except that one of the end sections may be with or without feed-thru connectors and lead-throughs, as was described before in this specification.

The end adapter 4 and/or the support element 5 may also provide protection for the gasket 6 against ultra violet light (UV). UV-light might embrittle the gasket 6 in the long run.

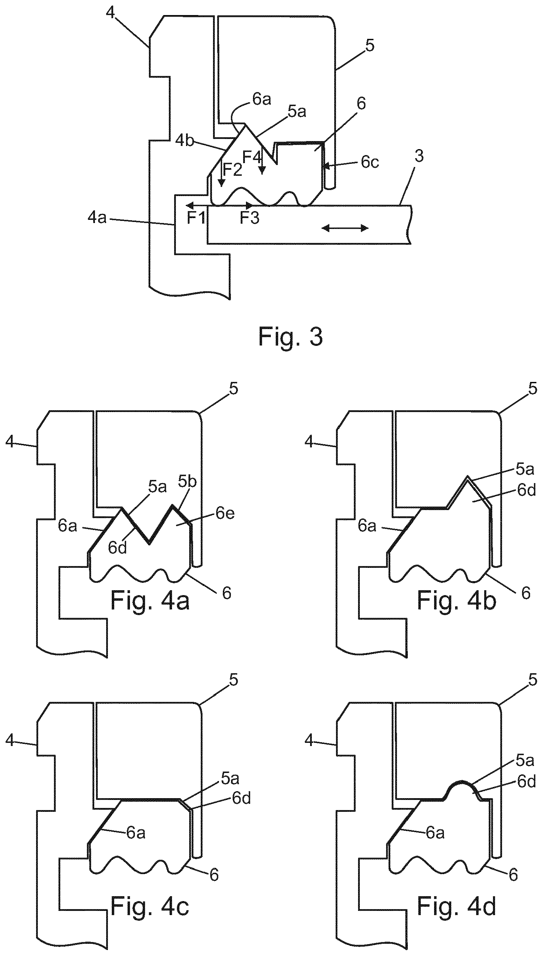

In accordance with an embodiment, an U-shaped or similar groove 5c (Figure 3) of the support element 5 and the corresponding protrusion of the gasket 6 may make it easier to install the gasket 6 at a correct location with reference to the support element 5.

The slit 4a may provide some free space for the end of the cover 3 so that the cover 3 does not so easily come into contact with the end adapter 4 due to, for example, temperature changes of the substrate 9, cover 3 and/or the end adapter 4.

When the end adapter 4 and the support element 5 are fixed together, the gasket 6 may be at least partly compressed by the end adapter 4, the support element 5 or both. This compression force may cause that a part of the gasket 6 presses more strongly on the surface of the cover 3 and thus improves the sealing. In other words, a compression force is induces which is directed towards the centre of the circumference of the gasket 6.

In accordance with an embodiment, the luminaire 1 may only comprise one end section described above. For example, the cover 3 may have opening in only one end and the other end of the cover 3 has been closed during manufacturing of the cover 3.

Figure 3 illustrates behaviour of the gasket 6, the support element 5, the end adapter 4, and the cover 3 due to temperature changes, in accordance with an embodiment. It may then happen that due to temperature raise, the length of the cover 3 may increase. This may lead to a situation in which the cover 3 tends to move towards the bottom of the slit 4a of the end adapter 4. Due to a friction between the gasket 6 and the surface of the cover 3 this movement may cause a force F1 at the contact point(s) 7 between the gasket 6 and the cover 3 which tends to move the gasket 6 with the cover 3. This force F1 pushes the first conical section 6a towards the corresponding conical section 4b of the end adapter 4. Because the surfaces of the conical sections 4b, 6a are at an angle different from 0° and 90°, a force F2 towards the surface of the cover 3 is induced. In other words, at least a part of the force F2 points towards a center of the inner circumference of the gasket 6. This force F2 presses the gasket 6 more tightly against the surface of the cover 3 and maintains the tightness of the sealing.

On the other hand, if temperature decreases, also the length of the cover 3 may decrease. This may lead to a situation in which the cover 3 tends to move away from the bottom of the slit 4a of the end adapter 4. Due to a friction between the gasket 6 and the surface of the cover 3 this movement may cause a force F3 at the contact point(s) 7 between the gasket 6 and the cover 3 which tends to move the gasket 6 with the cover 3. This force F3 pushes the second conical section 6d towards the corresponding conical section 5a of the support element 5. Because the surfaces of the conical sections 6d, 5a are at an angle different from 0° and 90°, a force F4 towards the surface of the cover 3 is induced. This force F4 presses the gasket 6 more tightly against the surface of the cover 3 and maintains the tightness of the sealing.

The above described sealing arrangement may also improve the tightness of the luminaire 1 when temperature coefficient of at least one of the gasket 6, the support element 5, the end adapter 4 and the cover 3 differs from temperature coefficient of the other parts. This means that some parts may enlarge and shrink more than other parts when temperature changes. Therefore, the conical sections of the gasket 6, the end adapter 4 and the support element 5 may cause that the gasket 6 is pressed towards the surface of the cover 3 with strong enough force to maintain the tightness of the sealing despite of temperature changes.

It should be noted here that the end adapter 4 need not be one part but may also consist two or more parts which may be installed into one piece. For example, there may be a separate part (not shown) which provides the conical section to be pressed against the first side 6b of the gasket 6.

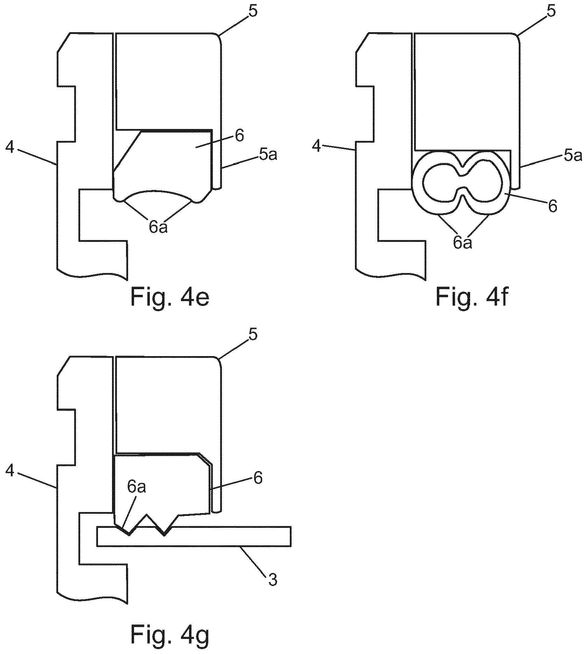

In accordance with an embodiment, the cover 3 may comprise grooves and/or protrusions corresponding with the one or more conical sections 6a of the gasket 6. The grooves and/or protrusions may be on the outer surface of the cover 3, on the inner surface of the cover 3 or both. In this embodiment, the end adapter 4 and the support element 5 may still induce similar compression to the gasket 6 so that at least the conical section 6a of the gasket 6 compresses against the grooves/protrusions of the surface of the cover 3 in the similar way than in the other embodiments described above. This is illustrated in Figure 4g.

Figures 4a to 4g depict some examples of cross sections of the gasket 6 and the support element 5. Figure 4a shows the structure of Figure 2 explained above, except that the gasket comprises another protrusion 6e and the support element 5 comprises a corresponding groove 5b. Figure 4b shows an example of a structure in which the second conical section 6d of the gasket is a protrusion, wherein the corresponding conical section 5a of the support element 5 is a groove. Figure 4c shows an example of a structure in which the second conical section 6d of the gasket is at the other side, opposite to the first conical section, wherein the corresponding conical section 5a of the support element 5 is formed in connection with the butt-end of the support element 5. Figure 4d shows an example of a structure in which the cross section of the second conical section 6d of the gasket is like a half circle, wherein the cross section of the corresponding conical section 5a of the support element 5 is also a half circle. Figure 4e shows an example of a structure in which the conical section 6a is directed towards the surface of the cover 3 and the end adapter 4 and the support element 5 form a kind of a U-shaped groove when they are fixed together. Figure 4f shows an example of a structure in which the cross section of the groove 6 resamples the number 8. Figure 4g shows an example of a structure in which the conical sections corresponding the conical sections 6a of the gasket 6 are made to the cover 3.

It should be noted here that also other forms for the conical sections 5a, 6a, 6d can be used, such as a parabola, a hyperbola, a part of a circle or a part of an ellipse or another kind of curve.

The material of the gasket 6 may be rubber, cellular rubber, foam or other at least partly elastic material. The gasket 6 need not be solid but may have one or more hollow sections inside the material.

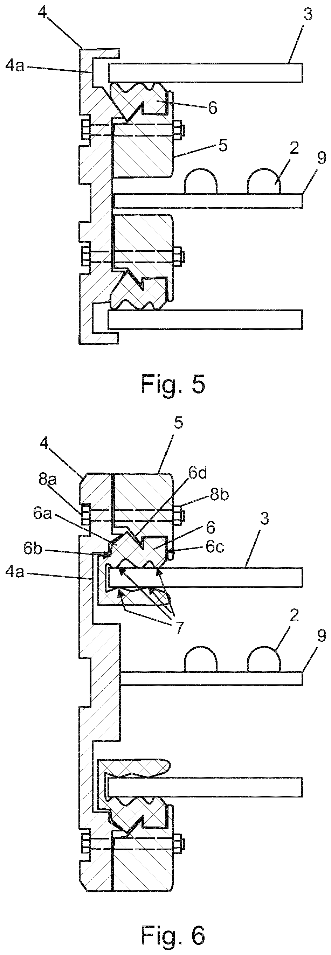

In the following the structure of the sealing apparatus of Figure 5 will be described. In this example the gasket 6 is arranged inside the cover 3, wherein at least part of the support element 5 is located inside the cover 3 of the electronic device 1 when the sealing apparatus is fixed with the cover 3. The cross section of the gasket 6 may be similar to the cross section of the gasket 6 in the embodiments where the gasket 6 is on the outer circumference of the cover 3. In this embodiment, the cover 3 may provide protection for the gasket 6 against UV-light. Furthermore, because the gasket 6 is inside the cover 3, water which may exist on the outer surface of the cover 3 may not easily become into contact with the gasket 6.

When the end adapter 4 and the support element 5 are attached with each other, they may compress the gasket 6 so that a part of the gasket 6 presses more strongly on the surface of the cover 3 and thus improves the sealing. In this embodiment, the compression force is directed away from the centre of the circumference of the gasket 6.

In one embodiment, the gasket 6 may extend on both inside and outside the cover 3 at the end of the cover 3. Hence, the end of the cover 3 may be located in a groove of the gasket 6. Figure 6 illustrates this in accordance with an embodiment.

The invention is not solely limited to the above described embodiments but may be varied within the scope of the appended claims.

## Claims

1. A sealing apparatus of an electronic device (1) to be used in hazardous areas comprising a cover (3), the sealing apparatus comprising:
a gasket (6) having an outer circumference, an inner circumference, and at least a first side (6b);
an end adapter (4) for closing the cover (3); and
a support element (5) for the gasket (6),
**characterized in that**
the gasket (6) comprises:
a first inclined surface (6a) with respect to a longitudinal direction of the cover (3) and which matches with a corresponding inclined surface (4b) of the end adapter (4) so that a force (F2) is induced towards the surface of the cover (3) when the length of the cover (3) increases for improving sealing between the gasket (6) and the cover (3);
a second inclined surface (6d) with respect to the longitudinal direction of the cover (3) and which matches with a correspondent inclined surface of the support element (5a) so that a force (F4) is induced towards the surface of the cover (3) when the length of the cover (3) decreases;
the end adapter (4) comprises a slit (4a) at the location of an end of the cover (3) for providing a free space between the end adapter (4) and the end of the cover (3);
wherein the first inclined surface (6a) of the gasket (6) is adapted to butt against the inclined surface (5b) of the end adapter (4) of the electronic device (1).

2. The sealing apparatus according to claim 1, **characterized in that**
the gasket (6) comprises a second conical section (6d) at the outer circumference of the gasket (6); and
the support element (5) comprises a conical section (5a) adapted to receive the second conical section (6d) of the gasket (6).

3. The sealing apparatus according to claim 2, **characterized in that**
the second conical section (6d) is a groove between the outer circumference and the inner circumference of the gasket (6).

4. The sealing apparatus according to claim 2, **characterized in that**
the second conical section (6d) is a protrusion between the outer circumference and the inner circumference of the gasket (6).

5. The sealing apparatus according to any of the claims 1 to 4, **characterized in that**
the end adapter (4) comprises a conical section adapted to form a butt contact with the first conical section (6a) of the gasket (6).

6. The sealing apparatus according to any of the claims 1 to 5, **characterized in that**
the first conical section (6a) of the gasket (6) is at the first side (6b) of the gasket (6).

7. An electronic device (1) comprising:
a cover (3);
a gasket (6) having an outer circumference, an inner circumference, and at least a first side (6b);
a support element (5) for the gasket (6); and
at least one end adapter (4) for closing the cover (3),
**characterized in that**
the gasket (6) comprises:
a first inclined surface (6a) with respect to a longitudinal direction of the cover (3) and which matches with a corresponding inclined surface (4b) of the end adapter (4) so that a force (F2) is induced towards the surface of the cover (3) when the length of the cover (3) increases for improving sealing between the gasket (6) and the cover (3);
a second inclined surface (6d) with respect to the longitudinal direction of the cover (3) and which matches with a correspondent inclined surface of the support element (5a) so that a force (F4) is induced towards the surface of the cover (3) when the length of the cover (3) decreases;
the end adapter (4) comprises a slit (4a) at the location of an end of the cover (3) for providing a free space between the end adapter (4) and the end of the cover (3);
wherein the first inclined surface (6a) of the gasket (6) is adapted to butt against the inclined surface (5b) of the end adapter of the electronic device (1).

8. The electronic device (1) according to claim 7 comprising the sealing apparatus according to any of the claims 2 to 6.

9. The electronic device (1) according to claim 7 or 8, **characterized in that**
the at least one end adapter (4) comprises one or more feed-thru connectors and/or one or more lead-throughs for leading cables into the luminaire (1).

10. The electronic device (1) according to claim 7, 8 or 9, **characterized in that**
the cover (3) is at least partly transparent, hollow tube.

11. The electronic device (1) according to claim 10, **characterized in that**
the electronic device (1) is a luminaire.

## Patentansprüche

1. Eine Abdichtungsvorrichtung einer elektronischen Einrichtung (1) zur Verwendung in gefährlichen Bereichen, die eine Abdeckung (3) aufweist, wobei die Abdichtungsvorrichtung Folgendes aufweist:
eine Dichtung (6) mit einem Außenumfang, einem Innenumfang und mindestens einer ersten Seite (6b);
einen Endadapter (4) zum Verschließen der Abdeckung (3); und
ein Halteelement (5) für die Dichtung (6),
**dadurch gekennzeichnet, dass**
die Dichtung (6) Folgendes aufweist:
eine erste geneigte Fläche (6a) in Bezug auf eine Längsrichtung der Abdeckung (3), die mit einer entsprechenden geneigten Fläche (4b) des Endadapters (4) zusammenpasst, so dass eine Kraft (F2) in Richtung zur Oberfläche der Abdeckung (3) induziert wird, wenn die Länge der Abdeckung (3) zunimmt, um die Abdichtung zwischen der Dichtung (6) und der Abdeckung (3) zu verbessern;
eine zweite geneigte Fläche (6d) in Bezug auf die Längsrichtung der Abdeckung (3), die mit einer entsprechenden geneigten Fläche des Halteelements (5a) zusammenpasst, so dass eine Kraft (F4) in Richtung zur Oberfläche der Abdeckung (3) induziert wird, wenn die Länge der Abdeckung (3) abnimmt;
wobei der Endadapter (4) einen Schlitz (4a) an der Stelle eines Endes der Abdeckung (3) aufweist, um einen freien Raum zwischen dem Endadapter (4) und dem Ende der Abdeckung (3) bereitzustellen;
wobei die erste geneigte Fläche (6a) der Dichtung (6) ausgestaltet ist, um an die geneigte Fläche (5b) des Endadapters (4) der elektronischen Einrichtung (1) anzustoßen.

2. Abdichtungsvorrichtung gemäß Anspruch 1, **dadurch gekennzeichnet, dass**
die Dichtung (6) einen zweiten konischen Abschnitt (6d) am Außenumfang der Dichtung (6) aufweist; und
das Halteelement (5) einen konischen Abschnitt (5a) aufweist, der ausgestaltet ist, um den zweiten konischen Abschnitt (6d) der Dichtung (6) aufzunehmen.

3. Abdichtungsvorrichtung gemäß Anspruch 2, **dadurch gekennzeichnet, dass**
der zweite konische Abschnitt (6d) eine Nut zwischen dem Außenumfang und dem Innenumfang der Dichtung (6) ist.

4. Abdichtungsvorrichtung gemäß Anspruch 2, **dadurch gekennzeichnet, dass**
der zweite konische Abschnitt (6d) ein Vorsprung zwischen dem Außenumfang und dem Innenumfang der Dichtung (6) ist.

5. Abdichtungsvorrichtung gemäß einem der Ansprüche 1 bis 4, **dadurch gekennzeichnet, dass**
der Endadapter (4) einen konischen Abschnitt aufweist, der ausgestaltet ist, um einen stumpfen Kontakt mit dem ersten konischen Abschnitt (6a) der Dichtung (6) zu bilden.

6. Abdichtungsvorrichtung gemäß einem der Ansprüche 1 bis 5, **dadurch gekennzeichnet, dass**
sich der erste konische Abschnitt (6a) der Dichtung (6) an der ersten Seite (6b) der Dichtung (6) befindet.

7. Eine elektronische Einrichtung (1), aufweisend:
eine Abdeckung (3);
eine Dichtung (6) mit einem Außenumfang, einem Innenumfang und mindestens einer ersten Seite (6b);
ein Halteelement (5) für die Dichtung (6); und
mindestens einen Endadapter (4) zum Schließen der Abdeckung (3), **dadurch gekennzeichnet, dass**
die Dichtung (6) Folgendes aufweist:
eine erste geneigte Fläche (6a) in Bezug auf eine Längsrichtung der Abdeckung (3), die mit einer entsprechenden geneigten Fläche (4b) des Endadapters (4) zusammenpasst, so dass eine Kraft (F2) in Richtung zur Oberfläche der Abdeckung (3) induziert wird, wenn die Länge der Abdeckung (3) zunimmt, um die Abdichtung zwischen der Dichtung (6) und der Abdeckung (3) zu verbessern;
eine zweite geneigte Fläche (6d) in Bezug auf die Längsrichtung der Abdeckung (3), die mit einer entsprechenden geneigten Fläche des Halteelements (5a) zusammenpasst, so dass eine Kraft (F4) in Richtung zur Oberfläche der Abdeckung (3) induziert wird, wenn die Länge der Abdeckung (3) abnimmt;
wobei der Endadapter (4) einen Schlitz (4a) an der Stelle eines Endes der Abdeckung (3) aufweist, um einen freien Raum zwischen dem Endadapter (4) und dem Ende der Abdeckung (3) bereitzustellen;
wobei die erste geneigte Fläche (6a) der Dichtung (6) ausgestaltet ist, um an die geneigte Fläche (5b) des Endadapters der elektronischen Einrichtung (1) anzustoßen.

8. Elektronische Einrichtung (1) gemäß Anspruch 7, die die Abdichtungsvorrichtung (6a) gemäß einem der Ansprüche 2 bis 6 aufweist.

9. Elektronische Einrichtung (1) gemäß Anspruch 7 oder 8, **dadurch gekennzeichnet, dass**
der mindestens eine Endadapter (4) einen oder mehrere Durchführungsverbinder (10) und/oder eine oder mehrere Durchführungen zum Einführen von Kabeln in den Beleuchtungskörper (1) aufweist.

10. Elektronische Einrichtung (1) gemäß Anspruch 7, 8 oder 9, **dadurch gekennzeichnet, dass**
die Abdeckung (3) ein zumindest teilweise transparentes, hohles Rohr ist.

11. Elektronische Einrichtung (1) gemäß Anspruch 10, **dadurch gekennzeichnet, dass**
die elektronische Einrichtung (1) ein Beleuchtungskörper ist.

## Revendications

1. Appareil d'étanchéité d'un dispositif électronique (1) destiné à être utilisé dans des zones de danger comprenant un moyen de recouvrement (3), l'appareil d'étanchéité comprenant :
une garniture d'étanchéité (6) qui présente une circonférence externe, une circonférence interne et au moins un premier côté (6b) ;
un adaptateur d'extrémité (4) pour fermer le moyen de recouvrement (3) ; et
un élément de support (5) pour la garniture d'étanchéité (6) ;
**caractérisé en ce que** la garniture d'étanchéité (6) comprend :
une première surface inclinée (6a) par rapport à une direction longitudinale du moyen de recouvrement (3) et qui est conjuguée avec une surface inclinée correspondante (4b) de l'adaptateur d'extrémité (4) de telle sorte qu'une force (F2) soit induite en direction de la surface du moyen de recouvrement (3) lorsque la longueur du moyen de recouvrement (3) augmente pour améliorer l'étanchéité entre la garniture d'étanchéité (6) et le moyen de recouvrement (3) ;
une seconde surface inclinée (6d) par rapport à la direction longitudinale du moyen de recouvrement (3) et qui est conjuguée avec une surface inclinée correspondante de l'élément de support (5a) de telle sorte qu'une force (F4) soit induite en direction de la surface du moyen de recouvrement (3) lorsque la longueur du moyen de recouvrement (3) diminue ;
l'adaptateur d'extrémité (4) comprend une fente (4a) au niveau de la localisation d'une extrémité du moyen de recouvrement (3) pour constituer un espace libre entre l'adaptateur d'extrémité (4) et l'extrémité du moyen de recouvrement (3) ;
dans lequel la première surface inclinée (6a) de la garniture d'étanchéité (6) est adaptée pour venir en butée contre la surface inclinée (5b) de l'adaptateur d'extrémité (4) du dispositif électronique (1).

2. Appareil d'étanchéité selon la revendication 1, **caractérisé en ce que** :
la garniture d'étanchéité (6) comprend une seconde section conique (6d) au niveau de la circonférence externe de la garniture d'étanchéité (6) ; et
l'élément de support (5) comprend une section conique (5a) qui est adaptée pour recevoir la seconde section conique (6d) de la garniture d'étanchéité (6).

3. Appareil d'étanchéité selon la revendication 2, **caractérisé en ce que** :
la seconde section conique (6d) est une gorge entre la circonférence externe et la circonférence interne de la garniture d'étanchéité (6).

4. Appareil d'étanchéité selon la revendication 2, **caractérisé en ce que** :
la seconde section conique (6d) est une protubérance entre la circonférence externe et la circonférence interne de la garniture d'étanchéité (6).

5. Appareil d'étanchéité selon l'une quelconque des revendications 1 à 4, **caractérisé en ce que** :
l'adaptateur d'extrémité (4) comprend une section conique qui est adaptée pour former un contact par venue en butée avec la première section conique (6a) de la garniture d'étanchéité (6).

6. Appareil d'étanchéité selon l'une quelconque des revendications 1 à 5, **caractérisé en ce que** :
la première section conique (6a) de la garniture d'étanchéité (6) est au niveau du premier côté (6b) de la garniture d'étanchéité (6).

7. Dispositif électronique (1) comprenant :
un moyen de recouvrement (3) ;
une garniture d'étanchéité (6) qui présente une circonférence externe, une circonférence interne et au moins un premier côté (6b) ;
un élément de support (5) pour la garniture d'étanchéité (6) ; et
au moins un adaptateur d'extrémité (4) pour fermer le moyen de recouvrement (3) ;
**caractérisé en ce que** la garniture d'étanchéité (6) comprend :
une première surface inclinée (6a) par rapport à une direction longitudinale du moyen de recouvrement (3) et qui est conjuguée avec une surface inclinée correspondante (4b) de l'adaptateur d'extrémité (4) de telle sorte qu'une force (F2) soit induite en direction de la surface du moyen de recouvrement (3) lorsque la longueur du moyen de recouvrement (3) augmente pour améliorer l'étanchéité entre la garniture d'étanchéité (6) et le moyen de recouvrement (3) ;
une seconde surface inclinée (6d) par rapport à la direction longitudinale du moyen de recouvrement (3) et qui est conjuguée avec une surface inclinée correspondante de l'élément de support (5a) de telle sorte qu'une force (F4) soit induite en direction de la surface du moyen de recouvrement (3) lorsque la longueur du moyen de recouvrement (3) diminue ;
l'adaptateur d'extrémité (4) comprend une fente (4a) au niveau de la localisation d'une extrémité du moyen de recouvrement (3) pour constituer un espace libre entre l'adaptateur d'extrémité (4) et l'extrémité du moyen de recouvrement (3) ;
dans lequel la première surface inclinée (6a) de la garniture d'étanchéité (6) est adaptée pour venir en butée contre la surface inclinée (5b) de l'adaptateur d'extrémité du dispositif électronique (1).

8. Dispositif électronique (1) selon la revendication 7, comprenant l'appareil d'étanchéité selon l'une quelconque des revendications 2 à 6.

9. Dispositif électronique (1) selon la revendication 7 ou 8, **caractérisé en ce que** :
l'au moins un adaptateur d'extrémité (4) comprend un ou plusieurs connecteur(s) traversant(s) d'alimentation et/ou un ou plusieurs moyen(s) de traversée filaire pour faire passer des câbles à l'intérieur du luminaire (1).

10. Dispositif électronique (1) selon la revendication 7, 8 ou 9, **caractérisé en ce que** :
le moyen de recouvrement (3) est un tube creux au moins partiellement transparent.

11. Dispositif électronique (1) selon la revendication 10, **caractérisé en ce que** :
le dispositif électronique (1) est un luminaire.
